# EUROPEAN PATENT APPLICATION

(11) **EP 0 961 307 A2**
(43) Date of publication of application: **01.12.1999**
(21) Application number: 99103443.0
(22) Date of filing: 23.02.1999
(51) Int. Cl.: H01J 37/32

(54) **Plasma CVD apparatus**

(30) Priority: 29.05.1998 JP 14861798; 29.05.1998 JP 14923098
(71) Applicant: Mitsubishi Heavy Industries, Ltd., Tokyo 100-0005 (JP)
(72) Inventor: Murata, Masayoshi Nagasaki Res. & Develop. Cent., 5-chome, Nagasaki, Nagasaki-ken (JP); Takeuchi, Yoshiaki Nagasaki Res. & Develop. Cent., 5-chome, Nagasaki, Nagasaki-ken (JP)
(74) Representative: Lins, Edgar, Dipl.-Phys. Dr.jur.

(57) **Abstract**

Disclosed is a plasma CVD apparatus, comprising a reaction vessel (21), a reactant gas introducing pipe (25) for introducing a reactant gas into the reaction vessel (21), an exhaust pipe (27) for withdrawing the waste gas including the reaction gas from within the reaction vessel (21), an anode electrode (23) arranged within the wreaction vessel (21) for supporting a substrate (24) to be processed and having a heat embedded therein, a cathode electrode (22) arranged within the reaction vessel (21) to face the anode electrode (23), and a high frequency power source (29) for supplying a high frequency power having a frequency of 30 to 200 MHz to the cathode electrode (29), glow discharge being generated by the power supplied from the high frequency power source (29) so as to form an amorphous, microcrystalline or polycrystalline thin film on the substrate (24) held on the anode electrode (23), wherein the high frequency power is supplied to the cathode electrode (22) through at least four power supply points, and a power distributor (31) is used for uniformly supplying the high frequency power to the cathode electrode (22).

## Description

The present invention relates to a plasma chemical vapor deposition apparatus (herein after referred to as a plasma CVD apparatus) for forming a thin film used in various electronic devices such as an amorphous silicon solar cell, a thin film semiconductor device, an optical sensor, and protective films for a semiconductor device.

The conventional plasma CVD apparatus used for forming a thin film of amorphous silicon (hereinafter referred to as a-Si) or a thin film of silicon nitride (hereinafter referred to as SiNₓ) can be roughly classified into two types, i.e., a ladder inductance electrode type using a ladder-shaped planar coil electrode for the discharge generation and a parallel plate electrode type.

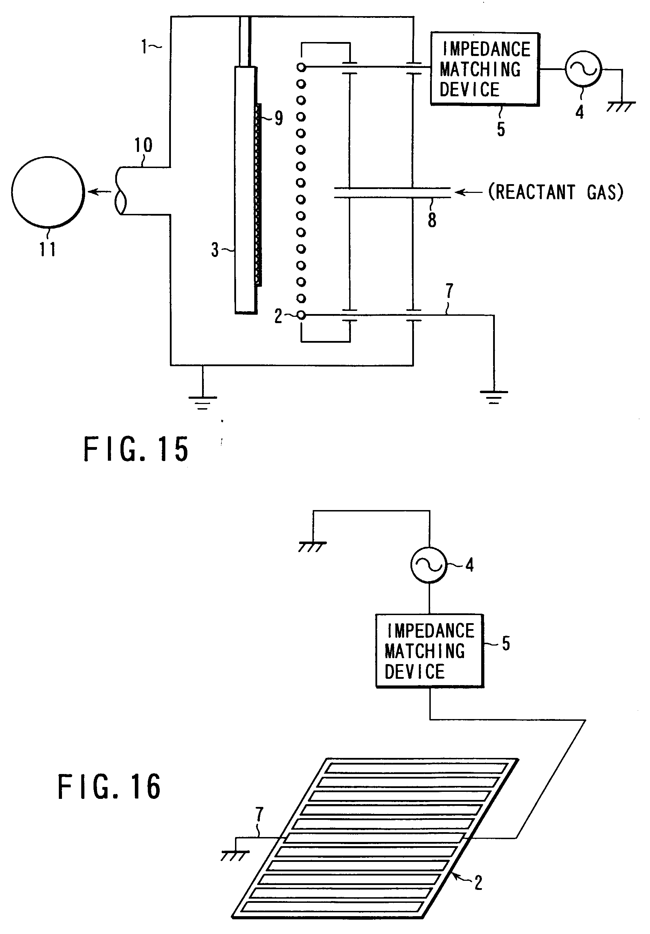

Plasma CVD apparatuses using various shapes of ladder-shaped planar coil electrodes are disclosed in, for example, Japanese Patent Disclosure (KOKAI) No. 4-236781. A typical plasma CVD apparatus disclosed in this prior art is shown in FIG. 15. As shown in the drawing, the plasma CVD apparatus comprises a reaction vessel 1. A ladder-shaped electrode 2 for discharge generation and a heater 3 for heating a substrate are arranged in parallel within the reaction vessel 1. A high frequency power having a frequency of, for example, 13.56 MHz is supplied from a high frequency power source 4 to the ladder-shaped electrode 2 for the discharge generation via an impedance matching device 5. As shown in FIG. 16, the ladder-shaped electrode 2 for the discharge generation is connected at one end to the high frequency power source 4 via the impedance matching device 5 and is connected at the other end to a ground lead 7 so as to be connected to the ground together with the reaction vessel 1.

The high frequency power supplied to the ladder-shaped electrode 2 serves to generate a glow discharge plasma in a free space between the substrate heater 3 and the ladder-shaped electrode 2. After generation of the glow discharge plasma, the high frequency power flows through the discharge space into the wall of the reaction vessel 1 and into the ground through the ground lead 7 connected to the ladder type electrode 2. A coaxial cable is used as the ground lead 7.

A mixed gas consisting of, for example, monosilane and hydrogen is supplied from a bomb (not shown) into the reaction vessel 1 through a reactant gas introducing pipe 8. The reactant gas introduced into the reaction vessel 1 is decomposed by a glow discharge plasma generated by the ladder type electrode 2 for discharge generation so as to be deposited on a substrate 9 disposed on the heater 3 and heated to predetermined temperature. On the other hand, the gas within the reaction vessel 1 is exhausted by a vacuum pump 11 through an exhaust pipe 10.

In preparing a thin film by using the apparatus described above, the inner space of the reaction vessel 1 is exhausted first by operating the vacuum pump 11, followed by introducing a mixed gas consisting of, for example, monosilane and hydrogen into the reaction vessel 1 through the reactant gas introducing pipe 8. In this step, the inner pressure of the reaction vessel 1 is maintained at 0.05 to 0.5 Torr. Under this condition, a high frequency power is supplied from the high frequency power source 4 to the ladder type electrode 2 for discharge generation so as to generate a glow discharge plasma. Therefore, the reactant gas is decomposed by the glow discharge plasma generated in the free space between the ladder type electrode 2 and the substrate so as to generate Si-containing radicals such as SiH₃ and SiH₂. These radicals are attached to a surface of the substrate 9 so as to form an a-Si thin film.

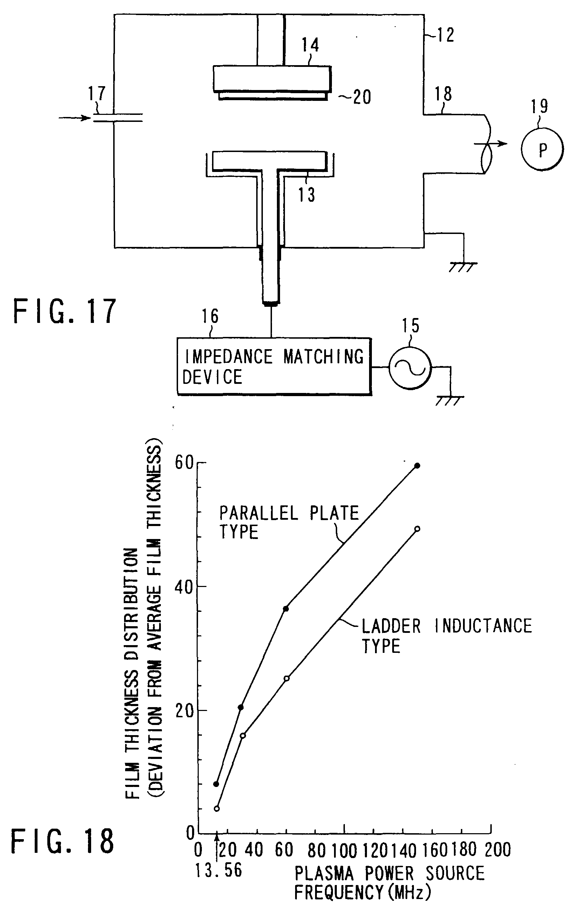

FIG. 17 shows another type of the conventional plasma CVD apparatus in which are used plate electrodes arranged in parallel. As shown in the drawing, the apparatus comprises a reaction vessel 12. A high frequency electrode 13 and a substrate heater 14 are arranged in parallel within the reaction vessel 12. A high frequency power having a frequency of, for example, 13.56 MHz is supplied from a high frequency power source 15 to the high frequency electrode 13 through an impedance matching device 16. The substrate heater 14 is connected to the reaction vessel 12. Also, the reaction vessel 12 is connected to the ground. It follows that the substrate heater 14 is indirectly connected to the ground to constitute a ground electrode, with the result that a glow discharge plasma is generated in the free space between the high frequency electrode 13 and the substrate 14.

A mixed gas consisting of, for example, monosilane and hydrogen is supplied from a bomb (not shown) into the reaction vessel 12 through a reactant gas introducing pipe 17. On the other hand, the gas within the reaction vessel 12 is exhausted by a vacuum pump 19 through an exhaust pipe 18. A substrate 20 is disposed on the substrate heater 14 so as to be heated to a predetermined temperature.

For forming a thin film by using the apparatus shown in FIG. 17, the inner space of the reaction vessel 12 is exhausted first by operating the vacuum pump 19, followed by introducing a mixed gas consisting of, for example, monosilane and hydrogen into the reaction vessel 12 through the reactant gas introducing pipe 17. In this step, the inner pressure of the reaction vessel 12 is maintained at 0.05 to 0.5 Torr. If a high frequency power is supplied from the high frequency power source 15 to the high frequency electrode 13, a glow discharge plasma is generated within the reaction vessel 12.

The monosilane gas contained in the mixed gas supplied through the reactant gas introducing pipe 17 into the reaction vessel 12 is decomposed by the glow discharge plasma generated in the free space between the high frequency electrode 13 and the substrate heater 14 so as to generate Si-containing radicals such as SiH₃ and SiH₂. These Si-containing radicals are attached to a surface of the substrate 20 so as to form an a-Si thin film.

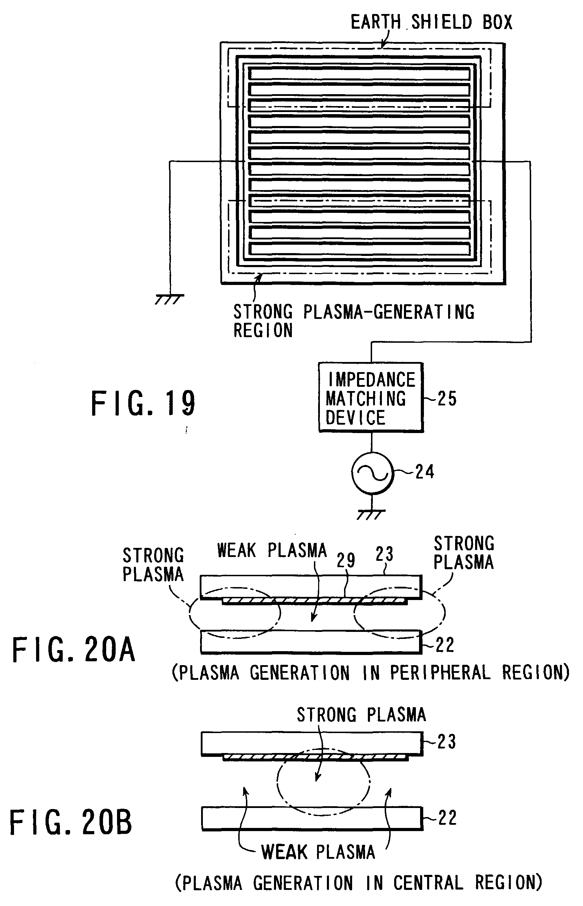

However, any of the prior arts using a ladder type electrode and plate electrodes arranged in parallel gives rise to problems as described below.
(1) In the conventional apparatus shown in FIG. 15, a reactant gas, e.g., SiH₄, is decomposed by an electric field generated in the vicinity of the ladder type electrode 2 into Si, SiH, SiH₂, SiH₃, H, H₂, etc. so as to form an a-Si film on the surface of the substrate 9. However, if the frequency of the high frequency power is increased from the present level of 13.56 MHz to 30 to 200 MHz in an attempt to increase the rate of forming the a-Si film, the electric field in the vicinity of the ladder type electrode fails to be distributed uniformly, leading to a markedly poor uniformity in the thickness of the formed a-Si. FIG. 18 is a graph showing the relationship between the plasma power source frequency and the film thickness distribution in respect of a substrate having an area of 30 cm × 30 cm. It should be noted that the size of the substrate which permits ensuring a uniformity in the film thickness distribution, i.e., deviation of ±10% from an average film thickness, is about 5 cm × 5 cm to about 20 cm x 20 cm.
   The reason why it is difficult to increase the frequency of the high frequency power source 4 in the apparatus using a ladder type electrode is as follows. Specifically, non-uniformity of impedance derived from the construction of the ladder type electrode is inherent in the apparatus shown in FIG. 15, with the result that a strong plasma light emission is localized, as shown in FIG. 19. For example, a strong plasma is generated in a peripheral portion alone of the ladder type electrode, and is not generated in a central portion. The difference in the plasma density between the peripheral portion and the central portion of the ladder type electrode is rendered prominent particularly where the frequency of the high frequency power source is increased to 60 MHz or more.
   Under the circumstances, it is very difficult and considered substantially impossible to increase the film forming rate by increasing the frequency of the plasma power source when it comes to a large substrate required for improving the mass productivity and cost reduction. It should be noted that the film forming rate of a-Si is proportional to the square of the frequency of the plasma power source. Therefore, vigorous researches are being made in this technical field on the technology to increase the frequency of the plasma power source. However, a successful result has not yet been reported in the case of a large substrate.
(2) In the conventional apparatus shown in FIG. 17, a reactant gas, e.g., SiH₄, is decomposed by an electric field generated in the free space between the high frequency electrode 13 and the substrate heater 14 into Si, SiH, SiH₂, SiH₃, H, H₂, etc. so as to form an a-Si film on the surface of the substrate 20. However, if the frequency of the high frequency power is increased from the present level of 13.56 MHz to 30 to 200 MHz in an attempt to increase the rate of forming the a-Si film, the electric field generated in the free space between the high frequency electrode 13 and the substrate heater 14 fails to be distributed uniformly, leading to a markedly poor uniformity in the thickness of the formed a-Si film. FIG. 18 is a graph showing the relationship between the plasma power source frequency and the film thickness distribution in respect of a substrate having an area of 30 cm × 30 cm. It should be noted that the size of the substrate which permits ensuring a uniformity in the film thickness distribution, i.e., deviation of ±10% from an average film thickness, is about 5 cm × 5 cm to about 20 cm × 20 cm.

The reason why it is difficult to increase the frequency of the high frequency power source 15 in the apparatus using plate electrodes arranged in parallel is as follows. Specifically, the peripheral portion and the central portion of the parallel plate type electrodes differ from each other in the electrical characteristics, with the result that a strong plasma is generated in the peripheral portions of the parallel plate electrodes 13 and 14 as shown in FIG. 20A, or a strong plasma is generated in the central portion alone of the parallel electrodes 13 and 14 as shown in FIG. 20B.

Under the circumstances, it is very difficult and considered substantially impossible to increase the film forming rate by increasing the frequency of the plasma power source when it comes to a large substrate required for improving the mass productivity and cost reduction. It should be noted that the film forming rate of a-Si is proportional to the square of the frequency of the plasma power source. Therefore, vigorous researches are being made in this technical field on the technology to increase the frequency of the plasma power source. However, a successful result has not yet been reported in the case of a large substrate.

An object of the present invention is to provide a plasma CVD apparatus comprising at least four power supply points connecting the cathode electrode to the power source and a power distributor for uniformly distributing the power supplied to the cathode electrode so as to obtain a film thickness distribution markedly superior to that obtained in the conventional apparatus.

Another object is to provide a plasma CVD apparatus comprising a vacuum power supply line for supplying a high frequency power to each cathode electrode and a power distributor connected to each cathode electrode via the vacuum power supply line for uniformly distributing the high frequency power so as to obtain a film thickness distribution markedly superior to that obtained in the conventional apparatus.

Still another object of the present invention is to provide a plasma CVD apparatus comprising an impedance converter interposed between the high frequency power source and the power distributor so as to obtain a further improved film thickness distribution.

According to an aspect of the present invention, there is provided a plasma CVD apparatus, comprising a reaction vessel, means for introducing a reactant gas into the reaction vessel, means for withdrawing the waste gas including the reaction gas from within the reaction vessel, an anode electrode arranged within the reaction vessel for supporting a substrate to be processed and having a heater embedded therein, a cathode electrode arranged within the reaction vessel to face the anode electrode, and a high frequency power source for supplying a high frequency power having a frequency of 30 to 200 MHz to the cathode electrode, glow discharge being generated by the power supplied from the high frequency power source so as to form an amorphous, microcrystalline or polycrystalline thin film on the substrate held on the anode electrode, wherein the high frequency power is supplied to the cathode electrode through at least four power supply points, and a power distributor is used for uniformly supplying the high frequency power to the cathode electrode.

According to another aspect of the present invention, there is provided a plasma CVD apparatus, comprising a reaction vessel, means for introducing a reactant gas into the reaction vessel, means for withdrawing the waste gas including the reaction gas from within the reaction vessel, an anode electrode arranged within the reaction vessel for supporting a substrate to be processed and having a heater embedded therein, a plurality of cathode electrodes arranged within the reaction vessel to face the anode electrode, and a high frequency power source for supplying a high frequency power having a frequency of 30 to 200 MHz to the cathode electrode, glow discharge being generated by the power supplied from the high frequency power source so as to form an amorphous, microcrystalline or polycrystalline thin film on the substrate held on the anode electrode, wherein the high frequency power is supplied to the cathode electrode through power supply lines for vacuum, and a power distributor is used for uniformly supplying the high frequency power to the cathode electrode.

This summary of the invention does not necessarily describe all necessary features so that the invention may also be a sub-combination of these described features.

This invention can be more fully understood from the following detailed description when taken in conjunction with the accompanying drawings, in which:
FIG. 1 shows the entire system of a plasma CVD apparatus according to one embodiment of the present invention;
FIG. 2 shows the electric wiring system for supplying a high frequency power to the cathode electrode included in the plasma CVD apparatus shown in FIG. 1;
FIG. 3 shows the construction of the cathode electrode included in the plasma CVD apparatus of the present invention, in which only one power supply terminal is mounted to a central portion of the cathode electrode;
FIG. 4 shows the construction of the cathode electrode included in the plasma CVD apparatus of the present invention, in which two power supply terminals are mounted to a central portion of the cathode electrode;
FIG. 5 shows the construction of the cathode electrode included in the plasma CVD apparatus of the present invention, in which four power supply terminals are mounted to a central portion of the cathode electrode;
FIG. 6 shows the construction of the cathode electrode included in the plasma CVD apparatus of the present invention, in which six power supply terminals are mounted to the cathode electrode;
FIG. 7 shows the construction of the cathode electrode included in the plasma CVD apparatus of the present invention, in which seven power supply terminals are mounted to the cathode electrode;
FIG. 8 shows the construction of the cathode electrode included in the plasma CVD apparatus of the present invention, in which eight power supply terminals are mounted to the cathode electrode;
FIG. 9 shows a power distributor included in the plasma CVD apparatus shown in FIG. 1;
FIG. 10 shows an impedance matching device included in the plasma CVD apparatus shown in FIG. 1;
FIG. 11 is a graph showing the relationship between the film thickness distribution and the number of power supply terminals, covering the case of using the cathode electrodes shown in FIGS. 3 to 8 under the condition that 500W of a high frequency power of 60 MHz was supplied to the cathode electrode;
FIG. 12 is a graph showing the relationship between the film thickness distribution and the number of power supply terminals, covering the case of using the cathode electrodes shown in FIGS. 3 to 8 under the condition that 500W of a high frequency power of 60 MHz was supplied to the cathode electrode without using an impedance converter;
FIG. 13 shows the entire system of a plasma CVD apparatus according to another embodiment of the present invention;
FIG. 14 shows the electric wiring system for supplying a high frequency power to the cathode electrode included in the plasma CVD apparatus shown in FIG. 13;
FIG. 15 shows a conventional plasma CVD apparatus using a ladder type electrode;
FIG. 16 shows an electric wiring for supplying a high frequency power to the ladder type electrode included in the conventional plasma CVD apparatus shown in FIG. 15;
FIG. 17 shows a conventional plasma CVD apparatus using parallel plate electrodes;
FIG. 18 is a graph showing the relationship between the film thickness distribution and the plasma power source frequency in the conventional plasma CVD apparatus;
FIG. 19 shows a non-uniform impedance in the conventional plasma CVD apparatus shown in FIG. 15; and
FIGS. 20A and 20B show the distribution of the plasma generation in the conventional plasma CVD apparatus shown in FIG. 17.

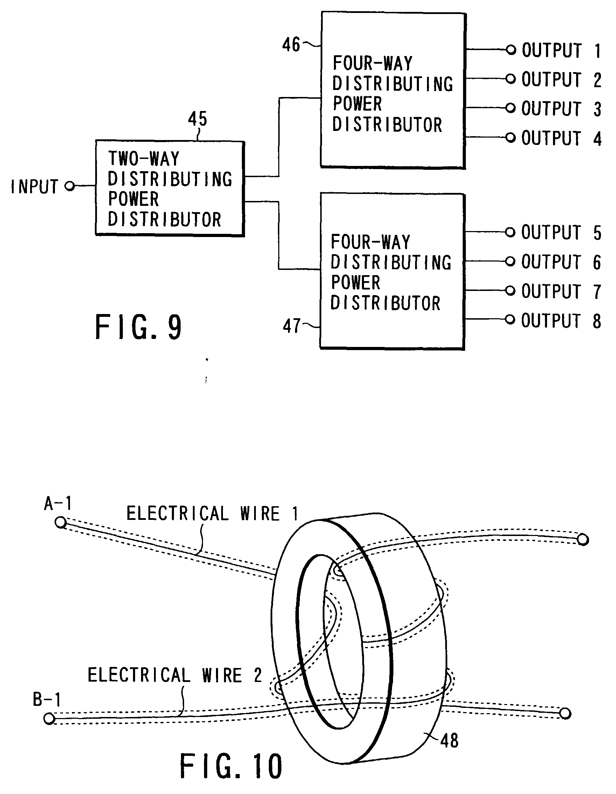

In the plasma CVD apparatus of the present invention, it is more desirable to have an impedance matching device interposed between the high frequency power source and the power distributor in order to further improve the film thickness distribution. The impedance matching device comprises a ferrite annular body and two insulated electric wires wound about the annular body, as shown in FIG. 10.

It is possible to use a general high frequency power distributor in the present invention. In addition, it is possible to use a power distributor comprising a transformer for a high frequency power having a frequency of 30 to 200 MHz, a resistor and a capacitor.

The cathode electrode included in the plasma CVD apparatus of the present invention is provided with at least four power supply points to which a high frequency power is supplied from the power source through the power distributor. In determining the power supply points to the cathode electrode, the cathode electrode is imaginarily divided equally into a plurality of sections, and a single power supply point is formed in the center of each of the equally divided sections of the cathode electrode. Where, for example, four power supply points are formed in the cathode electrode, the cathode electrode is imaginarily divided equally into four sections, and the power supply point is formed in the center of each of the divided sections.

### (Example 1)

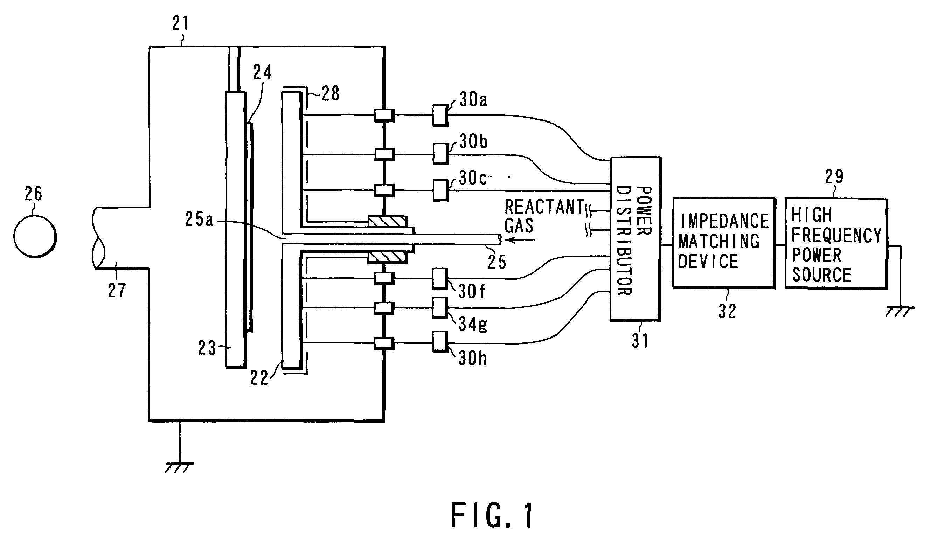

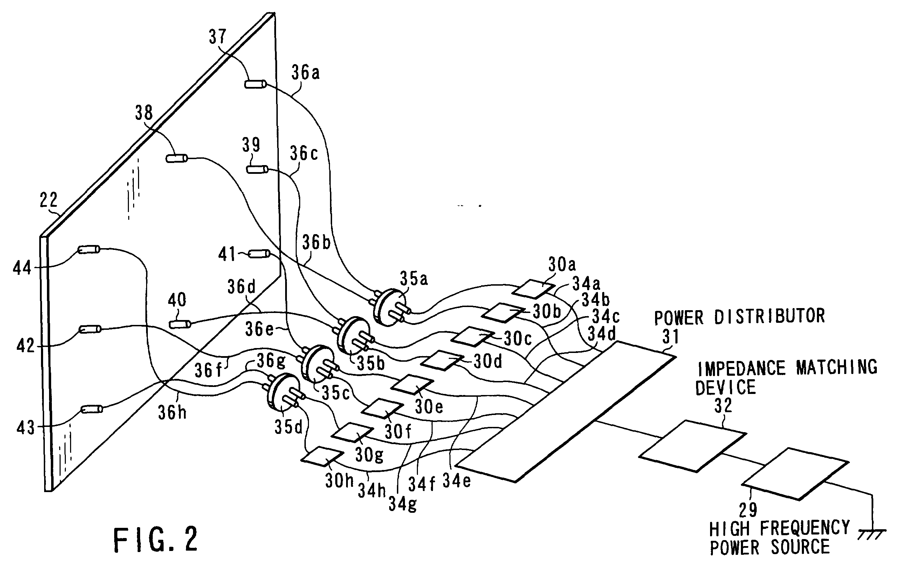

FIGS. 1 and 2 collectively show a plasma CVD apparatus according to a first embodiment of the present invention. Specifically, FIG. 1 shows the entire system of the plasma CVD apparatus, with FIG. 2 showing the electric wiring for supplying a high frequency power to the cathode electrode included in the plasma CVD apparatus shown in FIG. 1.

As shown in FIG. 1, a cathode electrode 22 made of SUS304 and an anode electrode 23 are arranged within a reaction vessel 21 to form parallel plate electrodes. A high frequency power is supplied to the cathode electrode 22, with the result that a glow discharge plasma is generated within a free space between the electrodes 22 and 23. A substrate 24 is supported on the anode electrode 23, and a heater (not shown) for heating the substrate 24 is embedded in the anode electrode 23. A reactant gas introducing pipe 25 having a reactant gas discharge port 25a is also arranged within the reaction vessel 21. A reactant gas is supplied through the reactant gas introducing pipe 25 into the free space between the cathode electrode 22 and the substrate 24.

A vacuum pump 26 is connected to the reaction vessel 21 via an exhaust pipe 27 for discharging the waste gas such as the reaction gas from within the reaction vessel 21. An earth shield 28 serving to suppress the discharge from undesired portions is also arranged within the reaction vessel 21. Incidentally, the pressure within the reaction vessel 21 is monitored by a pressure gage (not shown) and controlled by controlling the exhaust amount achieved by the vacuum pump 26.

If a high frequency power is applied to, for example, a SiH₄ gas supplied through the reactant gas introducing pipe 25 into the free space between the cathode electrode 22 and the substrate 24, a glow discharge plasma containing radicals such as SiH₃, SiH₂, and SiH is generated within the free space noted above. These radicals are diffused so as to be adsorbed on the surface of the substrate 24, with the result that a thin film of an a-Si, microcrystalline silicon or polycrystalline silicon is formed on the surface of the substrate 24. Incidentally, it is known to the art to form a thin film of any of an a-Si, microcrystalline silicon or polycrystalline silicon as desired by controlling appropriately the film forming conditions such as the reactant ratio of SiH₄ to H₂, reaction pressure and the high frequency power for the plasma generation. The following description covers the case where an a-Si thin film is formed by using a SiH₄ gas as a reactant gas. Needless to say, the technical idea of the present invention can be employed for forming a thin film of a microcrystalline silicon or polycrystalline silicon.

The cathode electrode 22 is connected to a high frequency power source 29 via a power supply line, which will be described herein later, impedance transformers 30a, 30b, 30c, 30d, 30e, 30f, 30g, 30h, a power distributor 31 and an impedance matching device 32.

FIG. 2 shows the electric wiring for supplying a high frequency power to the cathode electrode 22. As shown in the drawing, a high frequency power having a frequency of, for example, 60 MHz is supplied from the high frequency power source 29 to eight power supply terminals (power supply points) 37 to 44 welded to the cathode electrode 22 through the impedance matching device 32, a coaxial cable 33, a power distributor 31, coaxial cables 34a, 34b, 34c, 34d, 34e, 34f, 34g, 34h, impedance transformers 30a, 30b, 30c, 30d, 30e, 30f, 30g, 30h, current introducing terminals 35a, 35b, 35c, 35d and vacuum coaxial cables 36a, 36b, 36c, 36d, 36e, 36f, 36g, 36h. The cathode electrode 22 is formed of a SUS plate sized at 600 mm in width, 600 mm in length and 20 mm in thickness.

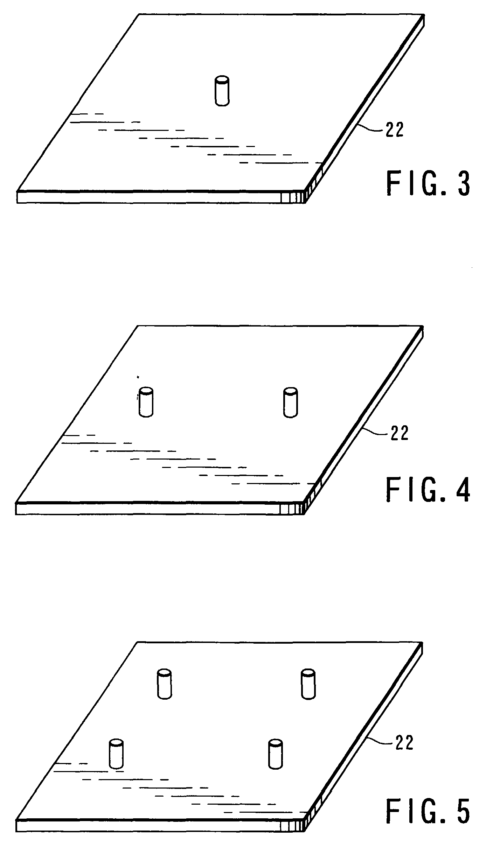

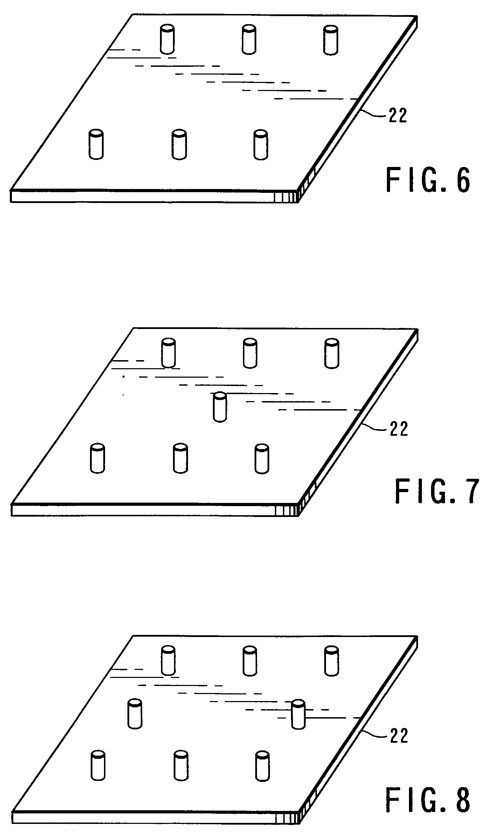

As described previously, the cathode electrode 22 included in the plasma CVD apparatus of the present invention is provided with at least four power supply points to which a high frequency power is supplied from the power source through the power distributor. In determining the power supply points to the cathode electrode, the cathode electrode is imaginarily divided equally into a plurality of sections, and a single power supply point is formed in the center of each of the equally divided sections of the cathode electrode, as shown in FIGS. 3 to 6. Where, for example, four power supply points are formed in the cathode electrode 22, the cathode electrode is imaginarily divided equally into four sections, and the power supply point is formed in the center of each of the divided sections, as shown in FIG. 5. Incidentally, FIG. 3 covers a reference case where only one power supply point is formed in the cathode electrode 22. In this case, the power supply point is formed in the center of the cathode electrode 22. Also, the arrangement of the power supply points shown in FIG. 4, in which two power supply points are formed, is for reference only and fails to fall within the technical scope of the present invention. Further, in the arrangement shown in FIG. 7, the cathode electrode 22 is imaginarily divided equally into six sections, and a power supply point is formed in the center of each of these divided sections. Also, an additional power supply point is formed in the center of the cathode electrode 22. Still further, in the arrangement shown in FIG. 8, the cathode electrode 22 is imaginarily divided equally into nine sections, and a power supply point is formed in the center of each of these divided sections except the central section.

The power distributor 31 comprises a two-way distributing power distributor 45 and four-way distributing power distributors 46 and 47, as shown in FIG. 9. It follows that the high frequency power supplied to the power distributor 31 is equally distributed to eight output terminals.

The impedance transformers 30a to 30h are for the matching of impedance among the power distributor 31, the vacuum coaxial cables 36a to 36h and the cathode electrode 22. As shown in FIG. 10, each of these impedance transformers comprises a ferrite annular body 48 and two insulated electric wires wound about the annular body 48. The ratio of one wire to the other wire in the number of turns of the winding about the annular body 48 is set at 2:3.

The plasma CVD apparatus of the construction described above is operated as follows for forming an a-Si thin film, In the first step, the vacuum pump 26 is operated to exhaust the reaction vessel 21 to set up a pressure within the reaction vessel at 2 to 3 × 10⁻⁷ Torr. Then, a reactant gas of, for example, SiH₄ gas is introduced through the reactant gas introducing pipe 25 into the reaction vessel 21 at a flow rate of about 80 to 200 SCCM, followed by supplying a high frequency power having a frequency of, for example, 60 MHz from the high frequency power source 29 to the cathode electrode 22 through the impedance matching device 32, the power distributor 31, the impedance transformers 30a to 30h and the vacuum coaxial cables 36a to 36h while maintaining the pressure within the reaction vessel at 0.05 to 0.1 Torr. As a result, a glow discharge plasma of SiH₄ is formed in the free space between the cathode electrode 22 and the anode electrode 23. The SiH₄ is decomposed by the plasma so as to form an a-Si film on the surface of the substrate 24. It should be noted that the film forming rate, which is dependent on the frequency and output of the high frequency power source 29, is about 0.5 to 3 nm/sec.

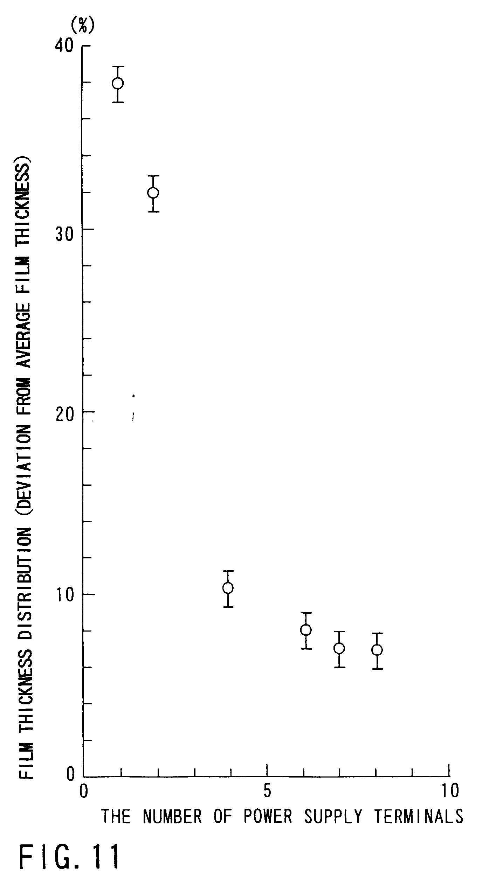

FIG. 11 is a graph showing the relationship between the film thickness distribution and the number of power supply points in the cathode electrode 22, covering the case where an a-Si film was formed on a substrate of Corning #7059 (trade name of a glass substrate manufactured by Corning Inc.) having an area of 40 cm × 50 cm by using the cathode electrodes 22 shown in FIGS. 3 to 8. The frequency of the high frequency power source 29 was 60 MHz. The a-Si film was formed under a SiH₄ gas flow rate of 600 SCCM, a pressure of 0.3 Torr and a high frequency power of 500W.

As shown in FIG. 11, the film thickness distribution was poor, i.e., ±38%, in the case where only one power supply terminal was formed in the cathode electrode 22. On the other hand, the film thickness distribution was ±32%, in the case where two power supply terminals were formed in the cathode electrode 22. Where four power supply terminals were formed in the cathode electrode 22, the film thickness distribution was ±10%. Where six power supply terminals were formed in the cathode electrode 22, the film thickness distribution was ±8%. Where seven power supply terminals were formed in the cathode electrode 22, the film thickness distribution was only ±7%. Further, where eight power supply terminals were formed in the cathode electrode 22, the film thickness distribution was only ±7%. In other words, the film thickness distribution is improved with increase in the number of power supply terminals formed in the cathode electrode 22.

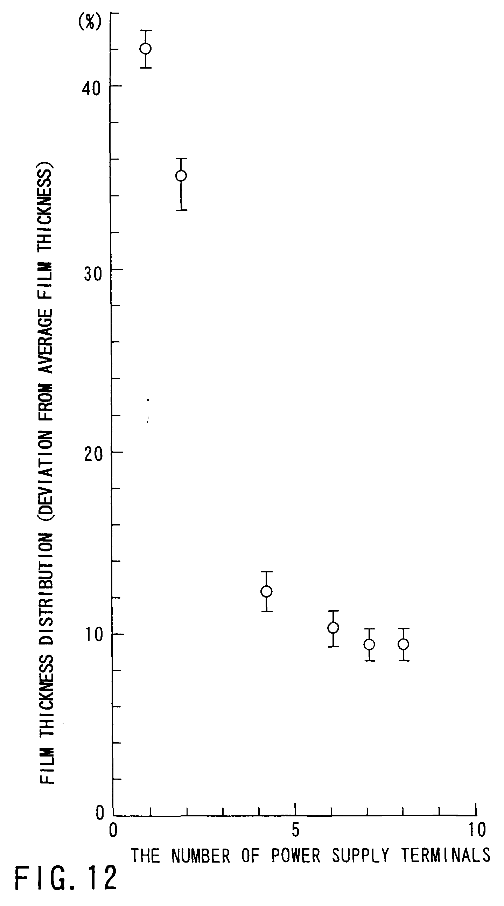

FIG. 12 is a graph showing the relationship between the film thickness distribution and the number of power supply points in the cathode electrode 22, covering the case where the impedance transformers 30a to 30h are removed from the apparatus so as to supply the high frequency power from the output terminals of the power distributor to the power supply points 37 to 44 of the cathode electrode 22 through the coaxial cables 34a to 34h, the current introducing terminals 35a to 35d, and the vacuum coaxial cables 36a to 36h. The film thickness distribution shown in FIG. 12 is somewhat inferior to that shown in FIG. 11. However, the film thickness distribution is not higher than ±10% in FIG. 12 where six to eight power supply points are formed in the cathode electrode 22. It should be noted that the film thickness distribution not higher than ±10% gives rise to no practical problem in performance in the manufacture of an a-Si solar cell, a thin film transistor and a photosensitive drum.

The plasma CVD apparatus according to the first embodiment of the present invention was found to be capable of obtaining a quite satisfactory film thickness distribution even in the case of using a high frequency power of 60 MHz, compared with the conventional plasma CVD apparatus, in the case where at least four power supply terminals, particularly at least six power supply terminals, were formed in the cathode electrode 22 to which a high frequency power was supplied. Particularly, the thickness distribution of the film formed on a substrate sized at 40 cm × 50 cm was found to be not higher than ±10% in the case where the frequency of the high frequency power source 29 was 60 MHz. This clearly supports that the plasma CVD apparatus of the present invention makes it possible to improve the productivity and to lower the manufacturing cost in the manufacture of an a-Si solar cell, a liquid crystal display device driven by a thin film transistor (TFT), and an a-Si photosensitive body, leading to a prominently high industrial value of the present invention.

In the conventional plasma CVD apparatus, however, the film thickness distribution was markedly poor in the case of using a high frequency power source having a frequency of 30 MHz or more, making it practically impossible to form a thin film on a large substrate sized at about 30 cm × 30 cm to about 50 cm × 50 cm.

### (Example 2)

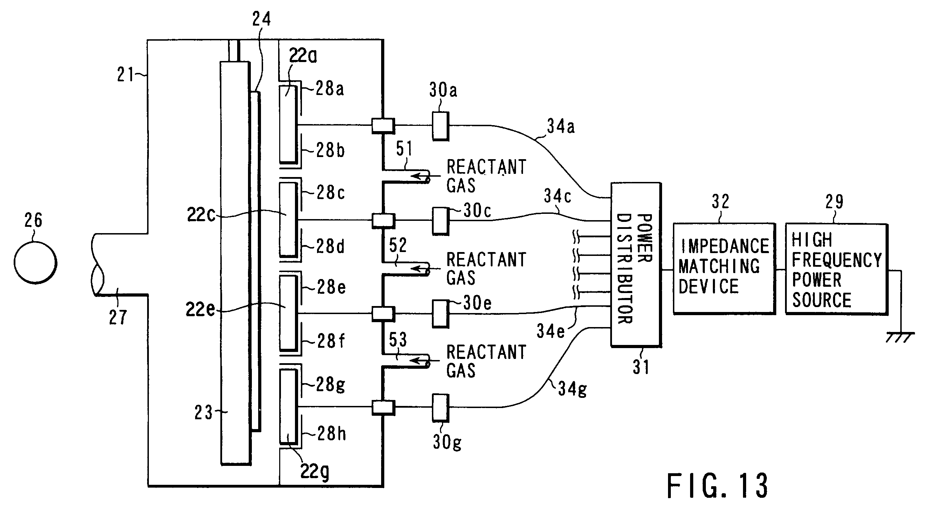

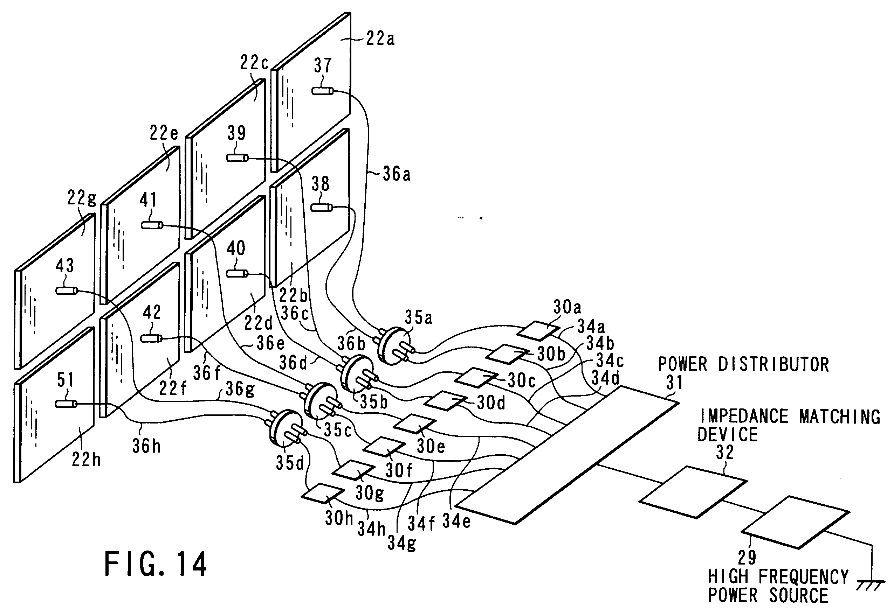

FIGS. 13 and 14 collectively show a plasma CVD apparatus according to a second embodiment of the present invention. Specifically, FIG. 13 shows the entire system of the plasma CVD apparatus, with FIG. 14 showing the electric wiring for supplying a high frequency power to the cathode electrode included in the plasma CVD apparatus shown in FIG. 13.

As shown in FIG. 13, cathode electrodes 22a, 22b, 22c, 22d, 22e, 22f, 22g, 22h each made of SUS304 and an anode electrode 23 are arranged within a reaction vessel 21. These cathode electrodes 22a to 22h are arranged within a plane parallel to the anode electrode 23 and apart from the anode electrode by 30 to 50 mm, with the result that these cathode electrodes 22a to 22h and the anode electrode 23 are arranged to form parallel plate electrodes. A high frequency power is supplied to the cathode electrodes 22a to 22h, with the result that a glow discharge plasma is generated within a free space between the cathode electrodes 22a to 22h and the anode electrode 23. A substrate 24 is supported on the anode electrode 23, and a heater (not shown) for heating the substrate 24 is embedded in the anode electrode 23.

Reactant gas introducing pipes 51, 52, 53 for introducing a reactant gas into the free space formed between the cathode electrodes 22a to 22h and the anode electrode 23 are also arranged within the reaction vessel 21. A vacuum pump 26 is connected to the reaction vessel 21 via an exhaust pipe 27 for discharging the waste gas such as the reaction gas from within the reaction vessel 21. Earth shields 28a, 28b, 28c, 28d, 28e, 28f, 28g, 28h serving to suppress the discharge from undesired portions are also arranged within the reaction vessel 21. Incidentally, the pressure within the reaction vessel 21 is monitored by a pressure gage (not shown) and controlled by controlling the exhaust amount achieved by the vacuum pump 26.

If a high frequency power is applied to, for example, a SiH₄ gas supplied through the reactant gas introducing pipe 51, 52, 53 into the free space between the cathode electrodes 22a to 22h and the substrate 24, a glow discharge plasma containing radicals such as SiH₃, SiH₂, and SiH is generated within the free space noted above. These radicals are diffused so as to be adsorbed on the surface of the substrate 24, with the result that a thin film of an a-Si, microcrystalline silicon or polycrystalline silicon is formed on the surface of the substrate 24. Incidentally, it is known to the art to form a thin film of any of an a-Si, microcrystalline silicon or polycrystalline silicon as desired by controlling appropriately the film forming conditions such as the reactant ratio of SiH₄ to H₂, reaction pressure and the high frequency power for the plasma generation. The following description covers the case where an a-Si thin film is formed by using a SiH₄ gas as a reactant gas. Needless to say, the technical idea of the present invention can be employed for forming a thin film of a microcrystalline silicon or polycrystalline silicon.

The cathode electrode 22a to 22h are connected to a high frequency power source 29 via vacuum coaxial cables 36a, 36b, 36c, 36d, 36e, 36f, 36f, 36h, which will be described herein later, impedance transformers 30a, 30b, 30c, 30d, 30e, 30f, 30g, 30h, a power distributor 31 and an impedance matching device 32.

FIG. 14 shows the electric wiring for supplying a high frequency power to the cathode electrode 22a to 22h. As shown in the drawing, a high frequency power having a frequency of, for example, 70 MHz is supplied from the high frequency power source 29 to eight power supply terminals (power supply points) 37 to 44 welded to the cathode electrode 22a to 22h through the impedance matching device 32, a power distributor 31, coaxial cables 34a, 34b, 34c, 34d, 34e, 34f, 34g, 34h, acting as power supply wires under vacuum, impedance transformers 30a, 30b, 30c, 30d, 30e, 30f, 30g, 30h, current introducing terminals 35a, 35b, 35c, 35d and vacuum coaxial cables 36a, 36b, 36c, 36d, 36e, 36f, 36g, 36h. Each of the cathode electrodes 22a to 22h is formed of a SUS plate sized at 220 mm in width, 220 mm in length and 20 mm in thickness.

The power distributor 31 comprises a two-way distributing power distributor 45 and four-way distributing power distributors 46 and 47, as shown in FIG. 9. It follows that the high frequency power supplied to the power distributor 31 is equally distributed to eight output terminals.

The impedance transformers 30a to 30h are for the matching of impedance among the power distributor 31, the vacuum coaxial cables 36a to 36h and the cathode electrodes 22a to 22h. As shown in FIG. 10, each of these impedance transformers comprises a ferrite annular body 48 and two insulated electric wires wound about the annular body 48. The ratio of one wire to the other wire in the number of turns of the winding about the annular body 48 is set at 1:4.

The plasma CVD apparatus of the construction described above is operated as follows for forming an a-Si thin film. In the first step, the vacuum pump 26 is operated to exhaust the reaction vessel 21 to set up a pressure within the reaction vessel at 2 to 3 × 10⁻⁷ Torr. Then, a reactant gas of, for example, SiH₄ gas is introduced through the reactant gas introducing pipes 51, 52, 53 into the reaction vessel 21 at a flow rate of about 500 to 800 SCCM, followed by supplying a high frequency power having a frequency of, for example, 70 MHz from the high frequency power source 29 to the cathode electrodes 22a to 22h through the impedance matching device 32, the power distributor 31, the impedance transformers 30a to 30h and the vacuum coaxial cables 36a to 36h while maintaining the pressure within the reaction vessel at 0.05 to 0.5 Torr. As a result, a glow discharge plasma of SiH₄ is formed in the free space between the cathode electrodes 22a to 22h and the anode electrode 23. The SiH₄ is decomposed by the plasma so as to form an a-Si film on the surface of the substrate 24. It should be noted that the film forming rate, which is dependent on the frequency and output of the high frequency power source 29, is about 0.5 to 3 nm/sec.

Table 1 shows experimental data, covering the case where an a-Si film was formed on a substrate Corning #7059 (trade name of a glass substrate manufactured by Corning Inc.) sized at 40 cm × 80 cm by using the cathode electrodes 22a to 22h shown in FIGS. 13 and 14. The frequency of the high frequency power source 29 used in this experiment was 70 MHz. The a-Si film was formed under a SiH₄ gas flow rate of 800 SCCM, a pressure of 0.3 Torr, and a high frequency power of 700W.

**Table 1**

| | film forming rate | film thickness distribution (deviation from average film thickness) |
|---|---|---|
| where impedance transformers 61a to 61h are not included | 1.2 nm/s | ±14% |
| where impedance transformers 61a to 61h are included | 1.2 nm/s | ±10% |
| (power source frequency 70 MHz, substrate area 40 cm × 80 cm) | | |

As described previously, an a-Si film was formed on a substrate sized at 40 cm × 80 cm under a power source frequency of 70 MHz. As shown in Table 1, satisfactory results which cannot be obtained in the conventional apparatus were obtained in this experiment. Specifically, the film thickness distribution was ±14% in the case where the impedance transformers were not included in the plasma CVD apparatus. On the other hand, the film thickness distribution was ±10% in the case where the impedance transformers were included in the plasma CVD apparatus.

It should be noted that the film thickness distribution not higher than ±10% gives rise to no practical problem in performance in the manufacture of an a-Si solar cell, a thin film transistor and a photosensitive drum.

In the plasma CVD apparatus according to the second embodiment of the present invention, the cathode electrode is divided into 8 small cathode electrodes 22a to 22h each sized at about 22 cm × 22 cm. These cathode electrodes 22a to 22h are arranged within the same plane, and a high frequency power is supplied from the high frequency power source 29 to these cathode electrodes 22a to 22h through the impedance matching device 32, the power distributor 31, the impedance transformers 30a to 30h and the vacuum coaxial cables 36a to 36h. The particular construction of the present invention makes it possible to form a quite satisfactory film thickness distribution even in the case of using a high frequency power of 70 MHz, compared with the conventional plasma CVD apparatus, though it was considered very difficult to use a high frequency power having such a high frequency for forming a thin film in the conventional plasma CVD apparatus.

Particularly, the thickness distribution of the film formed on a substrate sized at 40 cm × 80 cm was found to be not higher than ±10% in the case where the frequency of the high frequency power source 29 was 70 MHz. This clearly supports that the plasma CVD apparatus of the present invention makes it possible to improve the productivity and to lower the manufacturing cost in the manufacture of an a-Si solar cell, a liquid crystal display device driven by a thin film transistor (TFT), and an a-Si photosensitive body, leading to a prominently high industrial value of the present invention.

In the conventional plasma CVD apparatus, however, the film thickness distribution was markedly poor in the case of using a high frequency power source having a frequency of 30 MHz or more, making it practically impossible to form a thin film on a large substrate sized at about 30 cm × 30 cm to about 50 cm × 50 cm.

In each of the embodiments described above, the plasma CVD apparatus of the present invention was employed for forming an a-Si thin film. However, the plasma CVD apparatus using a high frequency power source having a frequency of 30 MHz to 200 MHz can be employed for forming a thin film of microcrystalline silicon and polycrystalline silicon. It follows that the plasma CVD apparatus of the present invention is highly advantageous in the manufacture of a solar cell, a thin film transistor, a photosensitive drum, etc.

## Claims

1. A plasma CVD apparatus, characterized by comprising:
a reaction vessel (21);
means for introducing a reactant gas into the reaction vessel (21);
means for withdrawing the waste gas including the reaction gas from within the reaction vessel (21);
an anode electrode (23) arranged within the reaction vessel (21) for supporting a substrate to be processed and having a heater embedded therein;
a cathode electrode (22) arranged within the reaction vessel (21) to face the anode electrode (23); and
a high frequency power source (29) for supplying a high frequency power having a frequency of 30 to 200 MHz to the cathode electrode (22), glow discharge being generated by the power supplied from the high frequency power source (29) so as to form an amorphous, microcrystalline or polycrystalline thin film on the substrate (24) held on the anode electrode (23),
wherein the high frequency power is supplied to the cathode electrode (22) through at least four power supply points, and a power distributor (31) is used for uniformly supplying the high frequency power to the cathode electrode (22).

2. A plasma CVD apparatus, characterized by comprising:
a reaction vessel (21);
means for introducing a reactant gas into the reaction vessel (21);
means for withdrawing the waste gas including the reaction gas from within the reaction vessel (21);
an anode electrode (23) arranged within the reaction vessel (21) for supporting a substrate (24) to be processed and having a heater embedded therein;
a plurality of cathode electrodes (22) arranged within the reaction vessel (21) to face the anode electrode (23); and
a high frequency power source (29) for supplying a high frequency power having a frequency of 30 to 200 MHz to the cathode electrode (22), glow discharge being generated by the power supplied from the high frequency power source (29) so as to form an amorphous, microcrystalline or polycrystalline thin film on the substrate (24) held on the anode electrode (23),
wherein the high frequency power is supplied to the cathode electrodes (22) through power supply lines for vacuum, and a power distributor (31) is used for uniformly supplying the high frequency power to the cathode electrode (22).

3. The plasma CVD apparatus according to claim 1 or claim 2, characterized in that an impedance matching device (32) is interposed between said power source (29) and said power distributor (31).

4. The plasma CVD apparatus according to claim 1 or claim 2, characterized in that said power distributor (31) comprises a high frequency transformer of 30 MHz to 200 MHz, a resistor and a capacitor.

5. The plasma CVD apparatus according to claim 1, characterized in that a high frequency power is supplied from said power source (29) to said cathode electrode (22) at not less than 6 power supply points formed in the cathode electrode (22).

6. The plasma CVD apparatus according to claim 3, characterized in that said impedance matching device (32) comprises a ferrite annular body and insulated electric wires wound about the ferrite annular body (48).
